# EUROPEAN PATENT APPLICATION

(11) **EP 4 704 520 A1**
(43) Date of publication of application: **04.03.2026**
(21) Application number: 25196445.8
(22) Date of filing: 18.08.2025
(51) Int. Cl.: H10D 84/83, H10D 84/85, H10D 89/10, H10D 84/80

(54) **INTEGRATED CELL DESIGN OF WELLTAP TO ADDRESS SUPPLY NOISE REDUCTION BY USING DECAP LENGTH OF DIFFUSION TRANSISTOR**

(30) Priority: 26.08.2024 IN 202441064372
(71) Applicant: NXP B.V., 5656 AG Eindhoven (NL)
(72) Inventor: Jain, Shreyans, 5656AG Eindhoven (NL); Kalra, Sachin, 5656AG Eindhoven (NL); Gayakwad, Pramod, 5656AG Eindhoven (NL); Agrawal, Gaurav, 5656AG Eindhoven (NL); J N, Ravi, 5656AG Eindhoven (NL)
(74) Representative: Colaiuda, Antonella

(57) **Abstract**

An integrated circuit device and associated methods of fabrication and operation are provided with a standard well tap cell disposed over a semiconductor substrate having first and second regions, where the standard well tap cell includes a first tie transistor disposed between a first plurality of LOD protection transistors in the first region, and a second tie transistor disposed between a second plurality of LOD protection transistors in the second region, where the first plurality of LOD protection transistors and the second plurality of LOD protection transistors include a first transistor connected as a first decoupling capacitor between a first voltage supply and a second voltage supply, a second transistor connected as a second decoupling capacitor between the first voltage supply and the second voltage supply, and a plurality of additional dummy transistors, each having a gate, source, and drain terminal connected in common to a supply voltage.

## Description

### BACKGROUND

### Field

The present disclosure is directed in general to integrated circuits (ICs). In one aspect, the present disclosure relates generally to an improved well tap cell design for integrated circuits.

### Description of the Related Art

Integrated circuit designs typically include numerous well tap cells distributed uniformly across the sea of gates region for providing well and substrate bias, where the spacing and distribution of well tap cells depends on the manufacturing technology node. In the sub-nanometer technology node, IC designs apply a Length of Diffusion (LOD) rule which defines a minimum distance from a shallow trench isolation (STI) oxide edge to an n-channel or p-channel of a FET device. The reason for the LOD rule is that STI regions create mechanical stresses in substrate areas where the diffusion is discontinuous, and these stresses can negatively impact device performance and functioning of functional transistors that are placed too near the discontinuous diffusion edges. In order to meet LOD rules in FinFET technology nodes (e.g., 16nm, 5nm), IC designers typically include a certain number of dummy transistors inside the well tap cell so that all functional transistors in the well tap cell will have uniform performance and functioning. However, there are significant design challenges and tradeoffs with including dummy transistors since they increase the size of the well tap cells, thereby consuming significant space in the design. As can be seen from the foregoing, the existing solutions for preventing mechanical stress impacts that can negatively impact device performance of functioning transistors in the well tap cell are extremely difficult at a practical level by virtue of the difficulty in balancing the cost, complexity, and circuit area requirements.

### BRIEF DESCRIPTION OF THE DRAWINGS

The present invention may be understood, and its numerous objects, features and advantages obtained, when the following detailed description of a preferred embodiment is considered in conjunction with the following drawings.
Figure 1 is a simplified plan view of the layout structure of a conventional well tap cell design which employs a dummy poly on oxide diffusion edge (PODE) transistor layout pattern to overcome Length of Diffusion (LOD) rule errors.
Figure 2 is a simplified cross sectional view of the conventional well tap cell design taken along a cross-sectional path shown in Figure 1 to illustrate the electrical connection of the well tap transistors and dummy PODE transistors forming the conventional well tap cell.
Figure 3 is a simplified plan view of the layout structure of a first CMOS well tap cell design which employs a pair of decap-coupled transistors in a first layout structure in accordance with selected embodiments of the present disclosure.
Figure 4 is a simplified cross sectional view of the first CMOS well tap cell design taken along a cross-sectional path shown in Figure 3 to illustrate the electrical connection of the well tap transistors and decap-coupled transistors forming the first CMOS well tap cell.
Figure 5 is a simplified plan view of the layout structure of a second CMOS well tap cell design which employs a pair of decap-coupled transistors in a second layout structure in accordance with selected embodiments of the present disclosure.
Figure 6 is a simplified cross sectional view of the second CMOS well tap cell design taken along a cross-sectional path shown in Figure 5 to illustrate the electrical connection of the well tap transistors and decap-coupled transistors forming the second CMOS well tap cell.
Figure 7 is a simplified plan view of the layout structure of a third PMOS well tap cell design which employs a pair of decap-coupled transistors in a third layout structure in accordance with selected embodiments of the present disclosure.
Figure 8 is a simplified cross sectional view of the third PMOS well tap cell design taken along a cross-sectional path shown in Figure 7 to illustrate the electrical connection of the well tap transistors and decap-coupled transistors forming the third PMOS well tap cell.
Figure 9 is a simplified plan view of the layout structure of a fourth NMOS well tap cell design which employs a pair of decap-coupled transistors in a fourth layout structure in accordance with selected embodiments of the present disclosure.
Figure 10 is a simplified cross sectional view of the fourth NMOS well tap cell design taken along a cross-sectional path shown in Figure 9 to illustrate the electrical connection of the well tap transistors and decap-coupled transistors forming the fourth NMOS well tap cell.
Figure 11 is a simplified plan view of the layout structure of a fifth CMOS well tap cell design which employs a pair of decap-coupled transistors in a fifth layout structure in accordance with selected embodiments of the present disclosure.
Figure 12 is a simplified cross sectional view of the fifth CMOS well tap cell design taken along a cross-sectional path shown in Figure 11 to illustrate the electrical connection of the well tap transistors and decap-coupled transistors forming the fifth CMOS well tap cell.
Figure 13 is a simplified plan view of the layout structure of a sixth CMOS well tap cell design which employs a pair of decap-coupled transistors in a sixth layout structure in accordance with selected embodiments of the present disclosure.
Figure 14 is a simplified cross sectional view of the sixth CMOS well tap cell design taken along a cross-sectional path shown in Figure 13 to illustrate the electrical connection of the well tap transistors and decap-coupled transistors forming the sixth CMOS well tap cell.
Figure 15 depicts a perspective view of an n-well tap cell formed with a decap-coupled PMOS FinFET and a dummy PMOS FinFET located on opposite sides of a centrally positioned n-well tie in accordance with selected embodiments of the present disclosure.
Figure 16 depicts a perspective view of a p-well tap cell formed with a decap-coupled NMOS FinFET and a dummy NMOS FinFET located on opposite sides of a centrally positioned p-well tie in accordance with selected embodiments of the present disclosure.
Figure 17 shows a flowchart depicting a method for fabricating an integrated circuit with a standard well tap cell design in accordance with selected embodiments of the present disclosure.

It will be appreciated that for simplicity and clarity of illustration, elements illustrated in the drawings have not necessarily been drawn to scale. For example, the dimensions of some of the elements are exaggerated relative to other elements for purposes of promoting and improving clarity and understanding. Further, where considered appropriate, reference numerals have been repeated among the drawings to represent corresponding or analogous elements.

### DETAILED DESCRIPTION

A compact standard well tap cell and associated methods of operation and fabrication are described for complying with Length of Diffusion (LOD) design rules by using "dummy" n-FinFET and p-FinFET devices to form decoupling capacitor (decap) structures which integrate seamlessly within the standard IC well tap cells to protect n-well and p-well taps. In selected embodiments, an integrated circuit structure is proposed that is footprint-compatible with existing well tap cells by converting dummy LOD transistors into decap structures which mitigate supply noise issues and voltage drop (or IR) issues that are increasingly prominent with the lower technology nodes and circuits running at high frequencies (in GHz range). To address these dynamic IR issues, the decap structures in each well tap cell act as local current sources that are connected between the supply and ground voltages to reduce IR drop for different supplies without requiring any routing overhead resources or silicon area or SoC design methodologies. And by uniformly distributing the well tap cells with incorporated decap-coupled dummy transistors across the SOC region, the power grid performance of the SoC is improved without increasing the chip area required for the well tap cells. While selected embodiments of the present disclosure are described hereinbelow with reference to various well tap cell configurations in which two decap-coupled dummy transistors are included in each well tap cell, it will be appreciated that additional or fewer decap-coupled dummy transistors may be included in each well tap cell in accordance the present disclosure, provided that at least one decap-coupled dummy transistor is included in each well tap cell.

As will be appreciated by those skilled in the art, integrated circuits are designed using standard design cells which are generated by system designers using commercially available design tools, such as electronic design automation (EDA) and computer aided design (CAD) tools, to integrate different electrical and/or logic functions into an integrated circuit (IC). In the context of the present disclosure, a standard well tap cell design may include a plurality of transistor devices (e.g., complementary FinFET) that are used to implement the electrical well tap function for electrically connecting the n-well to a supply voltage VDD and for connecting the p-well or substrate to the ground voltage VSS, but may also include additional dummy PODE transistors, along with additional transistors to implement logic functions, such as Boolean functions (e.g., AND, OR, NOT, and buffers), storage functions (e.g., flip-flops, and latches), and digital combinational functions (e.g., multiplexers and demultiplexers). With each standard cell having a predetermined geometry (width and height), the design tools include a library (known as a standard cell library) that stores the standard cell definitions for these logic functions which are selected and placed in rows and columns. Upon completing the placement, the semiconductor device design is simulated, verified, and subsequently transferred to a chip (i.e., formed in silicon).

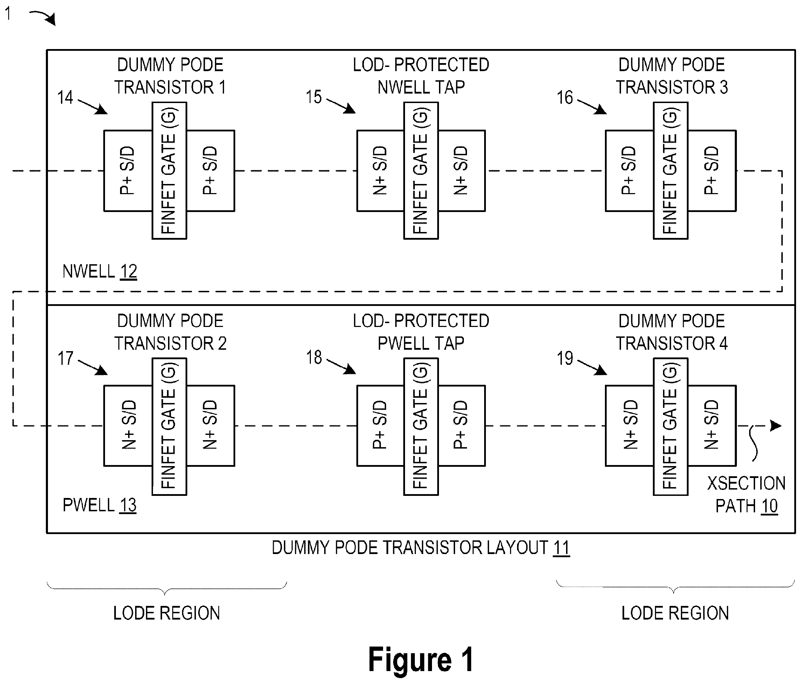

To provide a contextual understanding of the present disclosure, reference is now made to Figure 1 which shows a simplified plan view 1 of a single-row standard cell integrated circuit layout structure of a conventional well tap cell design which employs a dummy poly-on-oxide-diffusion edge (PODE) transistor layout pattern 11 where dummy FinFETs 14, 16, 17, 19 are placed on opposite sides of centrally located n-well and p-well taps 15, 18. The depicted dummy PODE transistor layout pattern 11 includes a plurality of transistor devices (e.g., complementary FinFET) 15, 18 that are used to implement n-well and p-well taps for connecting the supply voltage VDD and ground voltage VSS to the n-wells 12 and p-wells 13, respectively. In addition, the dummy PODE transistor layout pattern 11 includes a plurality of dummy FinFETs 14/16, 17/19 that are placed on either sides of centrally located n-well and p-well tap FinFETs 15, 18 in order to overcome Length of Diffusion (LOD) rule errors. As will be appreciated, the layout features depicted in the dummy PODE transistor layout pattern 11 do not include every element of the final device (such as gate layers or metal interconnects), but illustrate the relative location and placement of the dummy and well tap FinFETs 14-19, where the P+ FinFETs 14, 16 and N+ FinFETs 17, 19 are positioned as dummy transistors to protect, respectively, the N+ FinFET 15 and P+ FinFET 18 which form the centered p-well and n-well taps from STI stress effects.

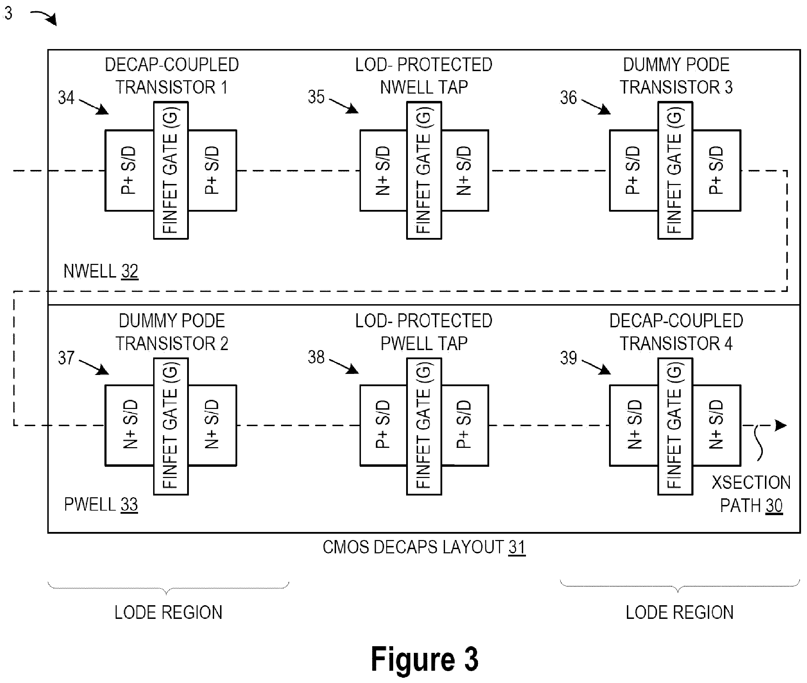

In the depicted example of a conventional well tap cell design, two parallel rows of FinFET devices 34-36, 37-39 are shown in Figure 3, but it will be appreciated that additional fin rows may be formed. In addition, the design rules will require active area gaps between adjacent FinFET devices and between individual FinFET devices and the peripheral edge of an n-well region or p-well region, though the arrangement, number, and placement of the gaps can vary based on the LOD design compliance requirements. Inside the depicted conventional well tap cell design, FinFET gate electrode layers (G) are formed to vertically extend across the cell to overlap with the n-well and p-well fins formed between the P+ and N+ source/drain (S/D) regions, thereby forming dummy p-FinFETs 14, 16 (in the n-well region 12) and dummy n-FinFETs 17, 19 (in the p-well region 13). These FinFET gate electrode layers are typically placed with a regular pattern and a constant pitch over the standard cell area, and they may also be used to electrically isolate functional FinFETs or blocks from dummy FinFETs if both of them reside in the same active area. With the formation of additional metal interconnect layers (not shown), the FinFET devices 34-39 may be connected to provide the required circuit functionality of the well tap cell design. In particular, the required circuit functionality of the well tap cell design includes at least a first pair of dummy FinFETs 14/16 located on opposite sides of the centrally positioned n-well tap FinFET 15 and a second pair of dummy FinFETs 17/19 located on opposite sides of the centrally positioned p-well tap FinFET 18. As will be appreciated, the dummy devices are formed from the "dummy" FinFETs by routing one or more metal interconnect layers to short the gate, source and drain terminals of the dummy FinFETs 14/16 to the supply voltage VDD, and to separately short the gate, source and drain terminals of the dummy FinFETs 17/19 to the ground voltage VSS.

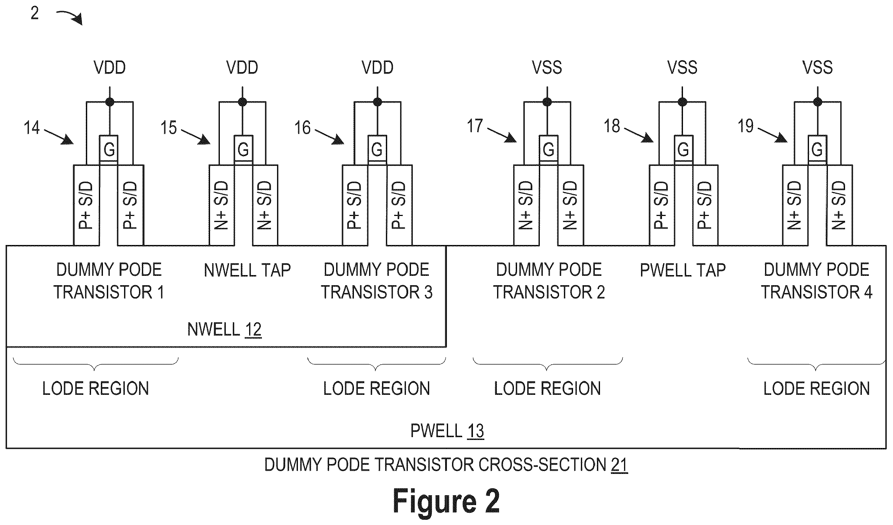

To illustrate the electrical connection of the LOD-protected well tap transistors 15, 18 and dummy PODE transistors 14, 16, 17, 19 forming the conventional well tap cell shown in Figure 1, reference is now made to Figure 2 which depicts a simplified cross sectional view 2 of the dummy PODE transistor layout pattern 21 for the conventional well tap cell design taken along the cross-sectional path shown 10 shown in Figure 1. As depicted, the n-well tap FinFET 15 formed over the n-well 12 includes an n-type fin structure that extends up from the n-well 12, that is sandwiched between N+ source/drain regions, and that is controlled by a FinFET gate (G) structure formed on the top and sides of the n-type fin structure, where the FinFET gate structure includes one or more polysilicon or metal layers formed over a gate dielectric or insulating layer. In addition, each of the depicted dummy PODE transistors 14, 16 formed over the n-well 12 includes an n-type fin structure that extends up from the n-well 12, that is sandwiched between P+ source/drain regions, and that is controlled by a FinFET gate (G) structure formed on the top and sides of the n-type fin structure. As depicted, each of the dummy PODE transistors 14, 16 and the n-well tap FinFET 15 have a supply voltage VDD connected to the shorted gate, source and drain regions. In this way, one or more N+ FinFETs 15 form the n-well tap for coupling the n-well region 12 to a first supply voltage VDD. In addition, the pair of N+ FinFETs 14, 16 form the dummy PODE transistors 14, 16 that are each connected as a FinFET dummy device between n-well region 12 and the first supply voltage VDD.

In similar fashion, the p-well tap FinFET 18 formed over the p-well 13 includes a p-type fin structure that extends up from the p-well 13, that is sandwiched between P+ source/drain regions, and that is controlled by a FinFET gate (G) structure formed on the top and sides of the p-type fin structure, where the FinFET gate structure includes one or more polysilicon or metal layers formed over a gate dielectric or insulating layer. In addition, each of the depicted dummy PODE transistors 17, 19 formed over the p-well 13 includes a p-type fin structure that extends up from the p-well 13, that is sandwiched between N+ source/drain regions, and that is controlled by a FinFET gate (G) structure formed on the top and sides of the p-type fin structure. As depicted, each of the dummy PODE transistors 17, 19 and the p-well tap FinFET 18 have a ground voltage VSS connected to the shorted gate, source and drain regions. In this way, one or more P+ FinFETs 18 form the p-well tap for coupling the p-well 13 to a second ground voltage VSS. In addition, the pair of P+ FinFETs 17, 19 form the dummy PODE transistors 17, 19 that are each connected as a FinFET dummy device between p-well region 13 and the second ground voltage VSS.

As will be appreciated by those skilled in the art, the dummy PODE transistors14, 16, 17, 19 are included and positioned to effectively absorb any non-uniform STI stress from outside the conventional well tap cell so that the FinFET channel regions of the n-well tap FinFET 15 and p-well tap FinFET 18 will experience uniform STI stress. However, as the design technology nodes get smaller, there are other electrical effects that increasingly impact device performance. For example, there are supply noise issues and voltage drop (or IR) issues that are increasingly prominent with the lower technology nodes and circuits running at high frequencies (in GHz range).

To address these shortcomings and deficiencies and others from the conventional well tap solutions, there is disclosed herein a compact standard well tap cell design wherein selected pairs of dummy PODE transistor devices are converted to, or replaced by, decoupling capacitor (decap) structures which integrate seamlessly within the standard IC well tap cells to protect n-well and p-well taps while improving IR performance without requiring routing resource overhead or increased silicon area. In selected embodiments, each decap structure is implemented with a MOSFET dummy device where the source and drain regions are shorted together to form a first decoupling capacitor plate that is connected to a first reference voltage, and where the gate terminal forms a second decoupling capacitor plate that is connected to a second reference voltage, thereby providing additional decoupling capacitance between the reference voltages. Such decap structure devices can be placed inside a standard cell array, thereby offering a huge area benefit compared to using conventional diodes which would break the alternating well pattern of the standard cell area and which would be difficult to integrate.

For an improved understanding of selected embodiments of the present disclosure, reference is now made to Figure 3 which depicts a simplified plan view 3 of a single-row standard cell integrated circuit layout structure having a first CMOS decap well tap cell design 31 which employs a pair of decap-coupled transistors 34, 39 and a pair of dummy FinFETs 36, 37 which are positioned to protect centrally located n-well and p-well taps 35, 38 against LOD rule errors while also increasing the decoupling capacitance between supply and ground to help mitigate the IR drop issues. The depicted first CMOS decap well tap cell design 31 includes a plurality of transistor devices (e.g., complementary FinFET) 35, 38 that are used to implement n-well and p-well taps for connecting the supply voltage VDD and ground voltage VSS to the n-wells 32 and p-wells 33, respectively. In addition, the first CMOS decap well tap cell design 31 includes a first decap-coupled transistor 34 and a first dummy PODE transistor 36 that are placed on either sides of centrally located n-well tap FinFET 35 to protect the N+ FinFET 35. The first CMOS decap well tap cell design 31 also includes a second dummy PODE transistor 37 and a second decap-coupled transistor 39 that are placed on either sides of centrally located p-well tap FinFET 38 to protect the P+ FinFET 38.

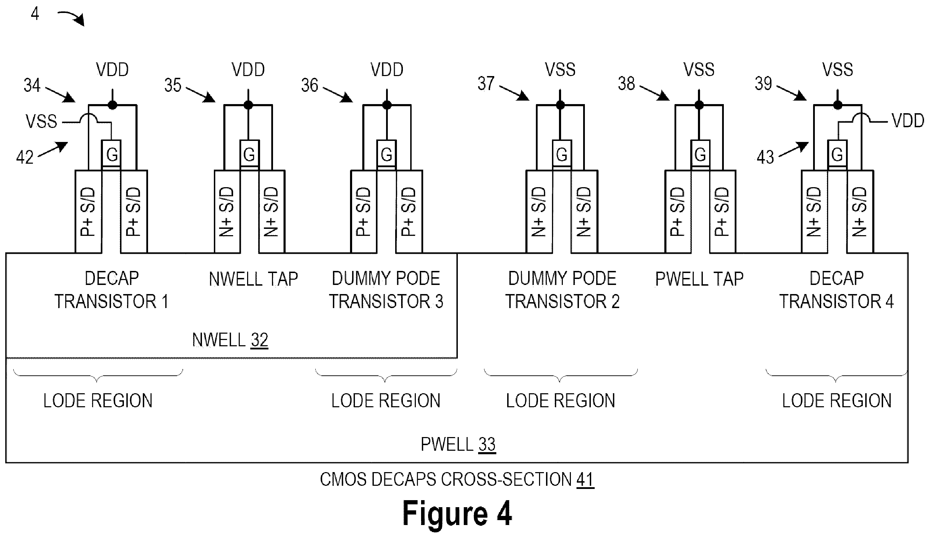

To illustrate the electrical connection of the LOD-protected well tap transistors 35, 38 in the first CMOS decap well tap cell design 31 shown in Figure 3, reference is now made to Figure 4 which depicts a simplified cross sectional view 4 of the first CMOS decap well tap cell design 41 taken along the cross-sectional path shown 30 shown in Figure 3. Except for the electrical connections to the supply and ground voltages, the FinFETs 34-39 may be structurally identical to the FinFETs 14-19 shown in Figures 1-2. As depicted, each of the dummy PODE transistors 36 and the n-well tap FinFET 35 formed in the n-well region 32 has a supply voltage VDD connected to the shorted gate, source and drain regions. Likewise, each of the dummy PODE transistors 37 and the p-well tap FinFET 38 formed in the p-well region 33 has a ground voltage VSS connected to the shorted gate, source and drain regions. However, with the formation of additional metal interconnect layers 42, the decap-coupled transistor 34 is connected in an open gated configuration where the P+ source/drain regions are shorted together and connected to the supply voltage VDD and where the gate electrode is connected to the ground voltage VSS, causing the decap-coupled transistor 34 to function as a "decoupling capacitor" ( e.g., by shunting or "decoupling" particular frequencies of a signal to ground). In addition, with the formation of additional metal interconnect layers 43, the decap-coupled transistor 39 is also connected in an open gated configuration where the N+ source/drain regions are shorted together and connected to the ground voltage VSS and where the gate electrode is connected to the supply voltage VDD, causing the decap-coupled transistor 39 to function as a "decoupling capacitor."

As depicted in Figures 3-4, the P+ and N+ decap-coupled transistors 34, 39 of the first CMOS decap well tap cell design 41 are positioned in LODE protection regions on opposed ends of the cross-sectional path 30 through the n-well region 32 and p-well region 33. In the n-well region 32, the P+ decap-coupled transistor 34 and dummy PODE transistor 36 combine to protect the n-well tap FinFET 35. In addition, the N+ decap-coupled transistor 39 and dummy PODE transistor 37 formed in the p-well region 33 combine to protect the p-well tap FinFET 38. The performance and/or functional benefits of positioning the decap-coupled transistors 34, 39 in opposed ends of the cross-sectional path 30 through the n-well region 32 and p-well region 33 include, but are not limited to providing additional capacitance.

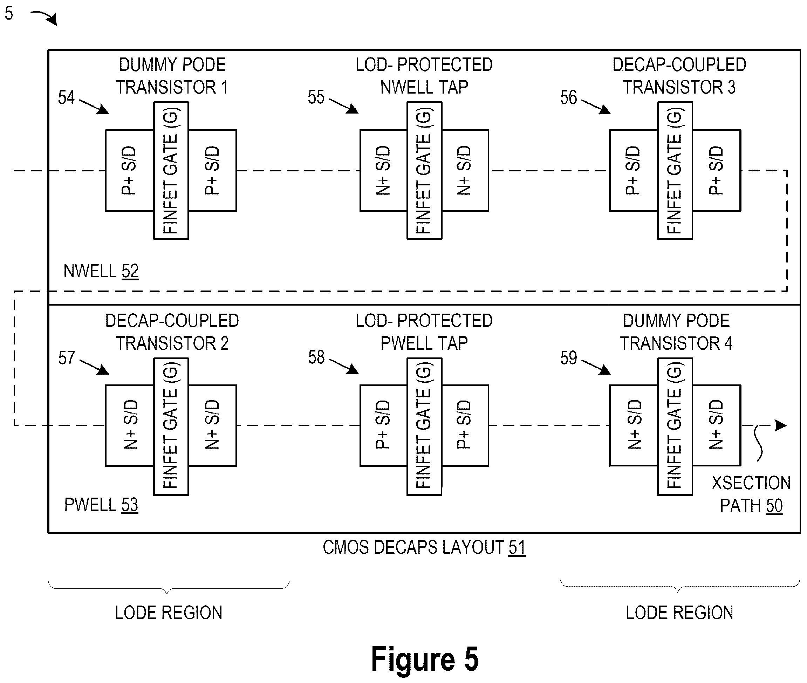

For an improved understanding of selected embodiments of the present disclosure, reference is now made to Figure 5 which depicts a simplified plan view 5 of a single-row standard cell integrated circuit layout structure having a second CMOS decap well tap cell design 51 which employs a pair of decap-coupled transistors 56, 57 and a pair of dummy FinFETs 54, 59 which are positioned to protect centrally located n-well and p-well taps 55, 58 against LOD rule errors while also increasing the decoupling capacitance between supply and ground to help mitigate the IR drop issues. The depicted second CMOS decap well tap cell design 51 includes a plurality of transistor devices (e.g., complementary FinFETs) 55, 58 that are used to implement n-well and p-well taps for connecting the supply voltage VDD and ground voltage VSS to the n-wells 52 and p-wells 53, respectively. In addition, the second CMOS decap well tap cell design 51 includes a first dummy PODE transistor 54 and a first decap-coupled transistor 56 that are placed on either sides of centrally located n-well tap FinFET 55. The second CMOS decap well tap cell design 51 also includes a second decap-coupled transistor 57 and a second dummy PODE transistor 59 that are placed on either sides of centrally located p-well tap FinFET 58.

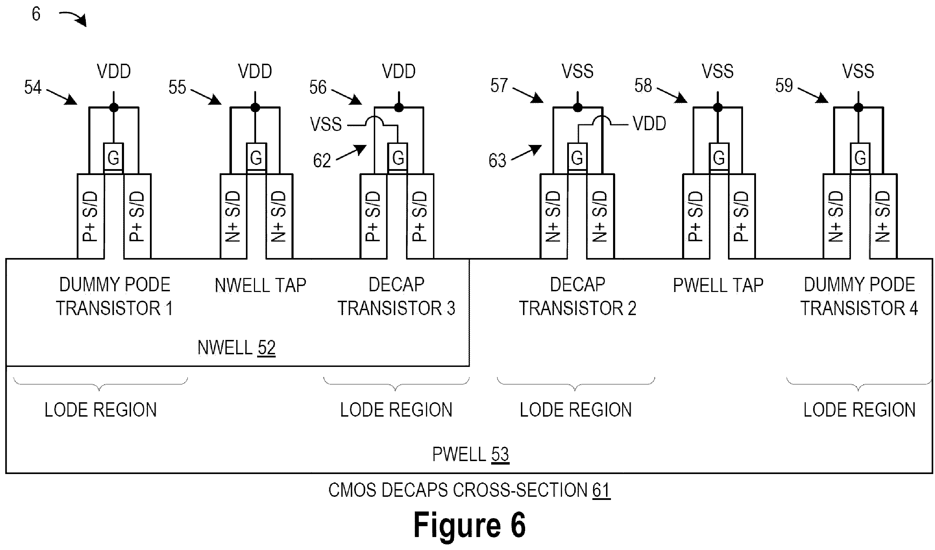

To illustrate the electrical connection of the LOD-protected well tap transistors 55, 58 in the second CMOS decap well tap cell design 51 shown in Figure 5, reference is now made to Figure 6 which depicts a simplified cross sectional view 6 of the second CMOS decap well tap cell design 61 taken along the cross-sectional path shown 50 shown in Figure 5. Except for the electrical connections to the supply and ground voltages, the FinFETs 56-57 may be structurally identical to the FinFETs 16-17 shown in Figures 1-2. As depicted, each of the dummy PODE transistors 56 and the n-well tap FinFET 55 formed in the n-well region 52 has a supply voltage VDD connected to the shorted gate, source and drain regions. Likewise, each of the dummy PODE transistors 59 and the p-well tap FinFET 58 formed in the p-well region 53 has a ground voltage VSS connected to the shorted gate, source and drain regions. However, with the formation of additional metal interconnect layers 62, the decap-coupled transistor 56 is connected in an open gated configuration where the P+ source/drain regions are shorted together and connected to the supply voltage VDD and where the gate electrode is connected to the ground voltage VSS. In addition, with the formation of additional metal interconnect layers 63, the decap-coupled transistor 57 is also connected in an open gated configuration where the N+ source/drain regions are shorted together and connected to the ground voltage VSS and where the gate electrode is connected to the supply voltage VDD.

As depicted in Figures 5-6, the P+ and N+ decap-coupled transistors 56, 57 of the second CMOS decap well tap cell design 61 are positioned in adjacent LODE protection regions of the cross-sectional path 50 through the n-well region 52 and p-well region 53. In the n-well region 52, the dummy PODE transistor 54 and P+ decap-coupled transistor 56 combine to protect the n-well tap FinFET 55. In addition, the N+ decap-coupled transistor 57 and dummy PODE transistor 59 formed in the p-well region 53 combine to protect the p-well tap FinFET 58. The performance and/or functional benefits of positioning the decap-coupled transistors 56, 57 in adjacent LODE protection regions along the cross-sectional path 50 through the n-well region 52 and p-well region 53 include, but are not limited to increasing the capacitance.

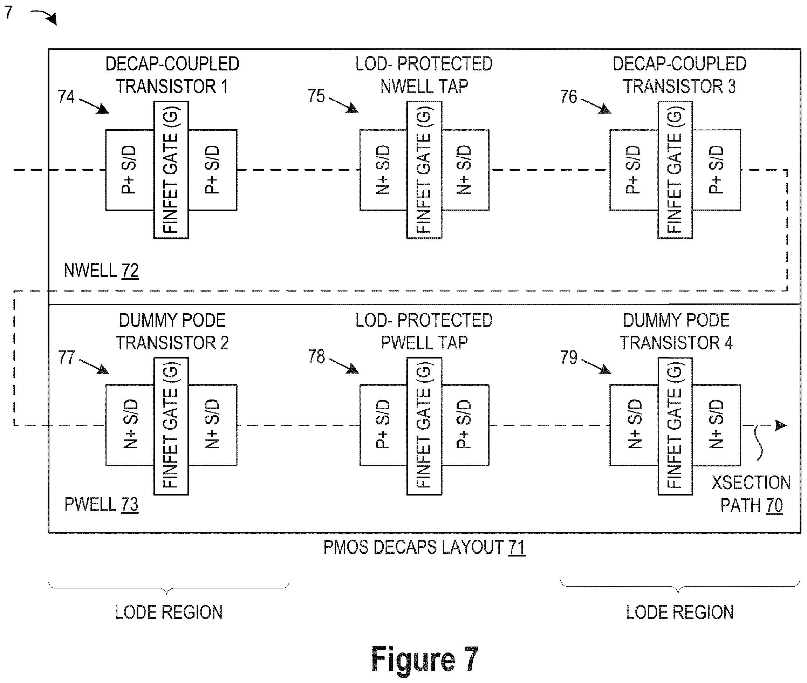

For an improved understanding of selected embodiments of the present disclosure, reference is now made to Figure 7 which depicts a simplified plan view 7 of a single-row standard cell integrated circuit layout structure having a third PMOS decap well tap cell design 71 which employs a pair of decap-coupled transistors 74, 76 and a pair of dummy FinFETs 77, 79 which are positioned to protect centrally located n-well and p-well taps 75, 78 against LOD rule errors while also increasing the decoupling capacitance between supply and ground to help mitigate the IR drop issues. The depicted third PMOS decap well tap cell design 71 includes a plurality of transistor devices (e.g., complementary FinFETs) 75, 78 that are used to implement n-well and p-well taps for connecting the supply voltage VDD and ground voltage VSS to the n-wells 72 and p-wells 73, respectively. In addition, the third PMOS decap well tap cell design 71 includes a first decap-coupled transistor 74 and a second decap-coupled transistor 76 that are placed on either sides of centrally located n-well tap FinFET 75. The third PMOS decap well tap cell design 71 also includes a first dummy PODE transistor 77 and a second dummy PODE transistor 79 that are placed on either sides of centrally located p-well tap FinFET 78.

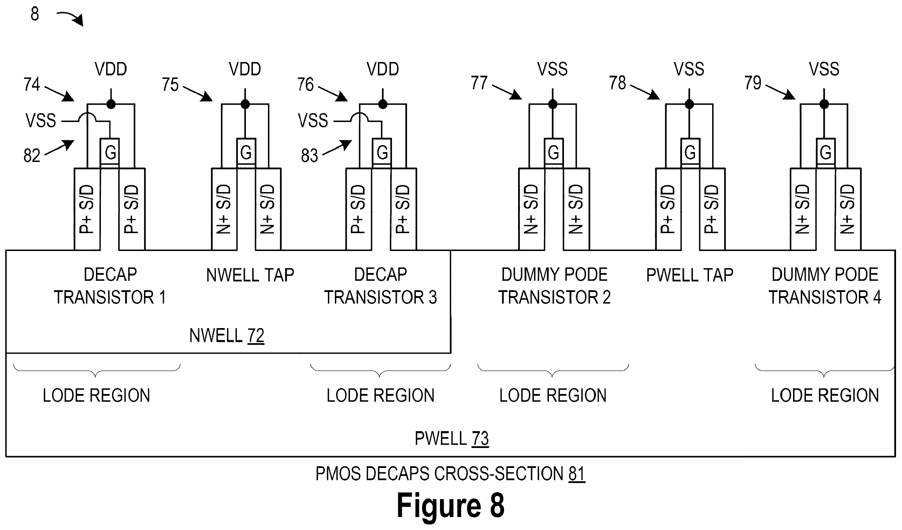

To illustrate the electrical connection of the LOD-protected well tap transistors 75, 78 in the third PMOS decap well tap cell design 71 shown in Figure 7, reference is now made to Figure 8 which depicts a simplified cross sectional view 8 of the third PMOS decap well tap cell design 71 taken along the cross-sectional path shown 70 shown in Figure 7. Except for the electrical connections to the supply and ground voltages, the FinFETs 74-76 may be structurally identical to the FinFETs 14-16 shown in Figures 1-2. As depicted, the n-well tap FinFET 75 formed in the n-well region 72 has a supply voltage VDD connected to the shorted gate, source and drain regions. Likewise, each of the first and second dummy PODE transistors 77, 79 and the p-well tap FinFET 78 formed in the p-well region 73 has a ground voltage VSS connected to the shorted gate, source and drain regions. However, with the formation of additional metal interconnect layers 82, 83, the first and second decap-coupled transistors 74, 76 are each connected in an open gated configuration where the P+ source/drain regions are shorted together and connected to the supply voltage VDD and where the gate electrode is connected to the ground voltage VSS.

As depicted in Figures 7-8, the P+ decap-coupled transistors 74, 76 of the third PMOS decap well tap cell design 71 are positioned in the LODE protection regions of the n-well region 72 to protect the n-well tap FinFET 75. In addition, the N+ dummy PODE transistors 77, 79 formed in the p-well region 73 combine to protect the p-well tap FinFET 78. The performance and/or functional benefits of positioning the decap-coupled transistors 74, 76 in LODE protection regions of the n-well region 72 include, but are not limited to reducing the current leakage and increasing the decoupling capacitance.

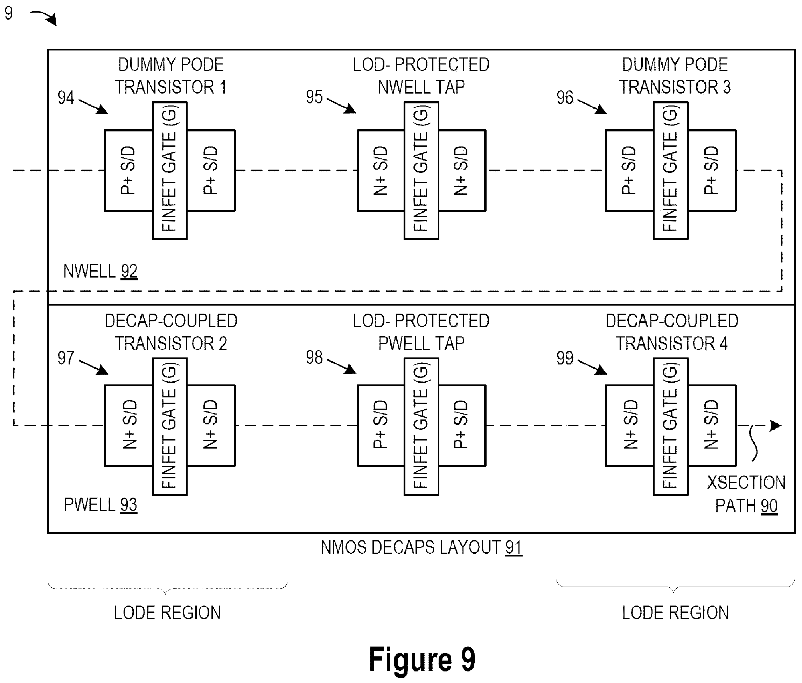

For an improved understanding of selected embodiments of the present disclosure, reference is now made to Figure 9 which depicts a simplified plan view 9 of a single-row standard cell integrated circuit layout structure having a fourth NMOS decap well tap cell design 91 which employs a pair of dummy FinFETs 94, 96 and a pair of decap-coupled transistors 97, 99 which are positioned to protect centrally located n-well and p-well taps 95, 98 against LOD rule errors while also increasing the decoupling capacitance between supply and ground to help mitigate the IR drop issues. The depicted fourth NMOS decap well tap cell design 91includes a plurality of transistor devices (e.g., complementary FinFETs) 95, 98 that are used to implement n-well and p-well taps for connecting the supply voltage VDD and ground voltage VSS to the n-wells 92 and p-wells 93, respectively. In addition, the fourth NMOS decap well tap cell design 91 includes a first dummy PODE transistor 94 and a second dummy PODE transistor 96 that are placed on either sides of centrally located n-well tap FinFET 95. The fourth NMOS decap well tap cell design 91 also includes a first decap-coupled transistor 97 and a second decap-coupled transistor 99 that are placed on either sides of centrally located p-well tap FinFET 98.

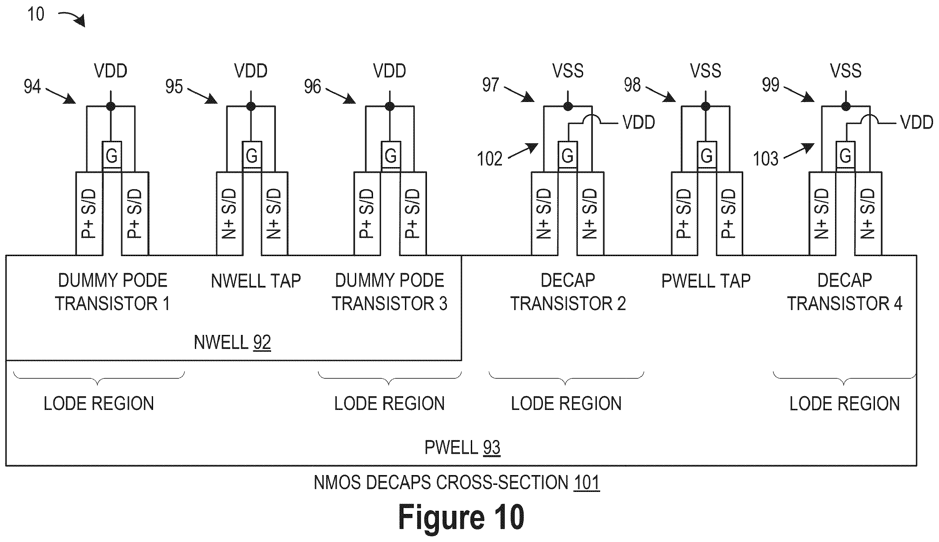

To illustrate the electrical connection of the LOD-protected well tap transistors 95, 98 in the fourth NMOS decap well tap cell design 91 shown in Figure 9, reference is now made to Figure 10 which depicts a simplified cross sectional view 10 of the fourth NMOS decap well tap cell design 91 taken along the cross-sectional path shown 90 shown in Figure 9. Except for the electrical connections to the supply and ground voltages, the FinFETs 97-99 may be structurally identical to the FinFETs 17-19 shown in Figures 1-2. As depicted, each of the first and second dummy PODE transistors 94, 96 and the n-well tap FinFET 95 formed in the n-well region 92 has a supply voltage VDD connected to the shorted gate, source and drain regions. Likewise, the p-well tap FinFET 98 formed in the p-well region 93 has a ground voltage VSS connected to the shorted gate, source and drain regions. However, with the formation of additional metal interconnect layers 102, 103, the first and second decap-coupled transistors 97, 99 are each connected in an open gated configuration where the N+ source/drain regions are shorted together and connected to the ground voltage VSS and where the gate electrode is connected to the supply voltage VDD.

As depicted in Figures 9-10, the N+ decap-coupled transistors 97, 99 of the fourth NMOS decap well tap cell design 91 are positioned in the LODE protection regions of the p-well region 93 to protect the p-well tap FinFET 98. In addition, the P+ dummy PODE transistors 94, 96 formed in the n-well region 92 combine to protect the n-well tap FinFET 95. The performance and/or functional benefits of positioning the decap-coupled transistors 97, 99 in LODE protection regions of the p-well region 93 include, but are not limited to increasing capacitance.

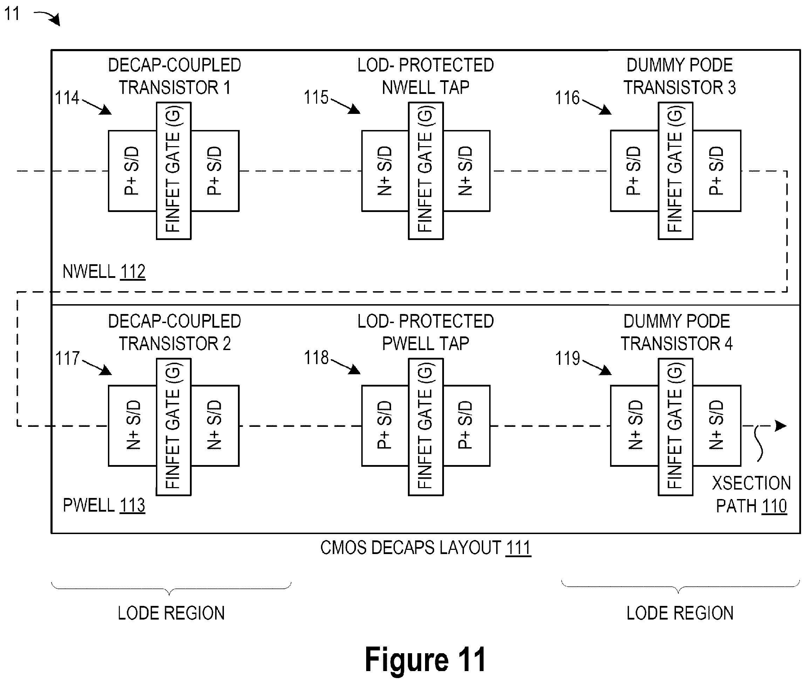

For an improved understanding of selected embodiments of the present disclosure, reference is now made to Figure 11 which depicts a simplified plan view 11 of a single-row standard cell integrated circuit layout structure having a fifth CMOS decap well tap cell design 111 which employs a pair of decap-coupled transistors 114, 117 and a pair of dummy FinFETs 116, 119 which are positioned to protect centrally located n-well and p-well taps 115, 118 against LOD rule errors while also increasing the decoupling capacitance between supply and ground to help mitigate the IR drop issues. The depicted fifth CMOS decap well tap cell design 111 includes a plurality of transistor devices (e.g., complementary FinFETs) 115, 118 that are used to implement n-well and p-well taps for connecting the supply voltage VDD and ground voltage VSS to the n-wells 112 and p-wells 113, respectively. In addition, the fifth CMOS decap well tap cell design 111 includes a first decap-coupled transistor 114 and a first dummy PODE transistor 116 that are placed on either sides of centrally located n-well tap FinFET 115. The fifth CMOS decap well tap cell design 111 also includes a second decap-coupled transistor 117 and a second dummy PODE transistor 119 that are placed on either sides of centrally located p-well tap FinFET 118.

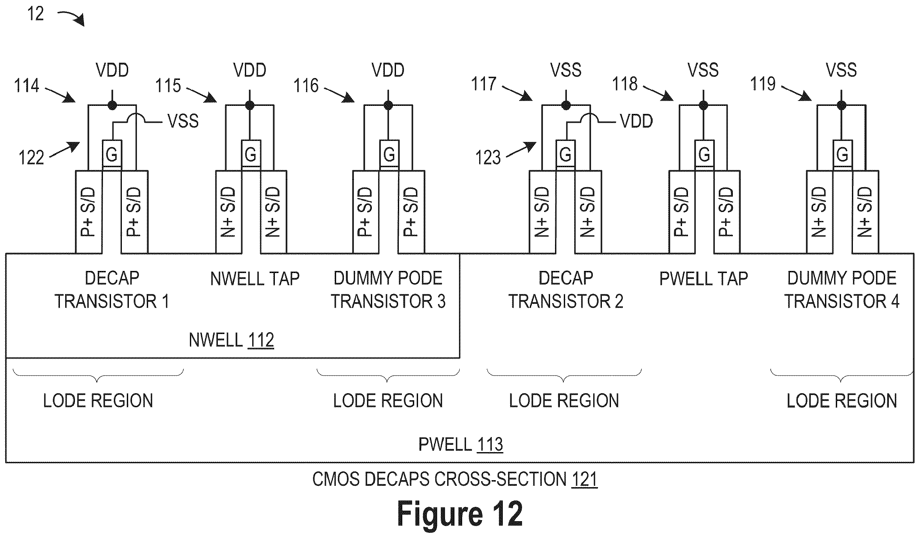

To illustrate the electrical connection of the LOD-protected well tap transistors 115, 118 in the fifth CMOS decap well tap cell design 111 shown in Figure 11, reference is now made to Figure 12 which depicts a simplified cross sectional view 12 of the fifth CMOS decap well tap cell design 111 taken along the cross-sectional path shown 110 shown in Figure 11. Except for the electrical connections to the supply and ground voltages, the FinFETs 114-117 may be structurally identical to the FinFETs 14-17 shown in Figures 1-2. As depicted, each of the dummy PODE transistors 116 and the n-well tap FinFET 115 formed in the n-well region 112 has a supply voltage VDD connected to the shorted gate, source and drain regions. Likewise, each of the dummy PODE transistors 119 and the p-well tap FinFET 118 formed in the p-well region 113 has a ground voltage VSS connected to the shorted gate, source and drain regions. However, with the formation of additional metal interconnect layers 122, the decap-coupled transistor 114 is connected in an open gated configuration where the P+ source/drain regions are shorted together and connected to the supply voltage VDD and where the gate electrode is connected to the ground voltage VSS. In addition, with the formation of additional metal interconnect layers 123, the decap-coupled transistor 117 is also connected in an open gated configuration where the N+ source/drain regions are shorted together and connected to the ground voltage VSS and where the gate electrode is connected to the supply voltage VDD.

As depicted in Figures 11-12, the P+ and N+ decap-coupled transistors 114, 117 of the fifth CMOS decap well tap cell design 111 are positioned in alternating LODE protection regions of the cross-sectional path 110 through the n-well region 112 and p-well region 113. In the n-well region 112, the P+ decap-coupled transistor 114 and dummy PODE transistor 116 combine to protect the n-well tap FinFET 115. In addition, the N+ decap-coupled transistor 117 and dummy PODE transistor 119 formed in the p-well region 113 combine to protect the p-well tap FinFET 118. The performance and/or functional benefits of positioning the decap-coupled transistors 114, 117 in alternating LODE protection regions along the cross-sectional path 110 through the n-well region 112 and p-well region 113 include, but are not limited to increasing capacitance.

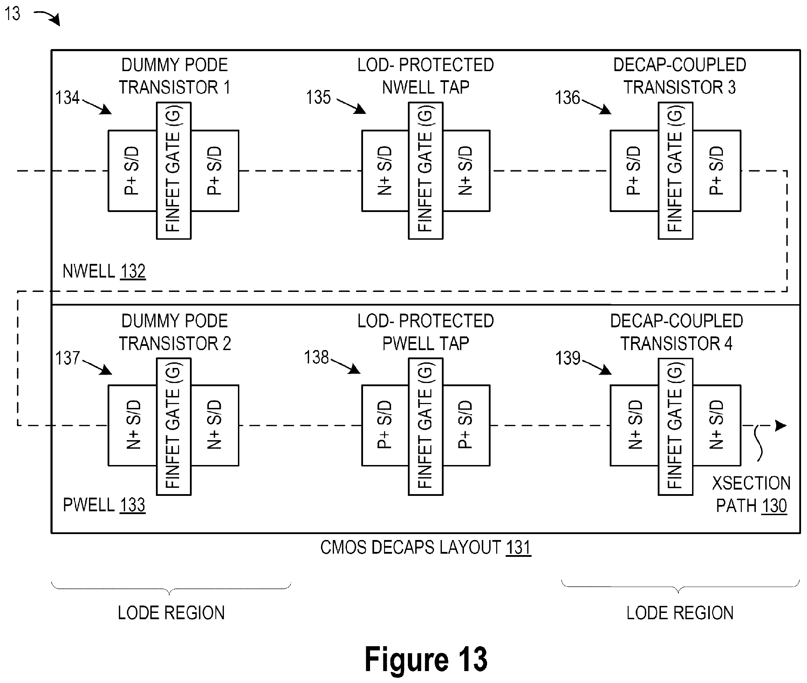

For an improved understanding of selected embodiments of the present disclosure, reference is now made to Figure 13 which depicts a simplified plan view 13 of a single-row standard cell integrated circuit layout structure having a sixth CMOS decap well tap cell design 131 which employs a pair of decap-coupled transistors 136, 139 and a pair of dummy FinFETs 134, 137 which are positioned to protect centrally located n-well and p-well taps 135, 138 against LOD rule errors while also increasing the decoupling capacitance between supply and ground to help mitigate the IR drop issues. The depicted sixth CMOS decap well tap cell design 131 includes a plurality of transistor devices (e.g., complementary FinFETs) 135, 138 that are used to implement n-well and p-well taps for connecting the supply voltage VDD and ground voltage VSS to the n-wells 132 and p-wells 133, respectively. In addition, the sixth CMOS decap well tap cell design 131 includes a first dummy PODE transistor 134 and a first decap-coupled transistor 136 that are placed on either sides of centrally located n-well tap FinFET 135. The sixth CMOS decap well tap cell design 131 also includes a second dummy PODE transistor 137 and a second decap-coupled transistor 139 that are placed on either sides of centrally located p-well tap FinFET 138.

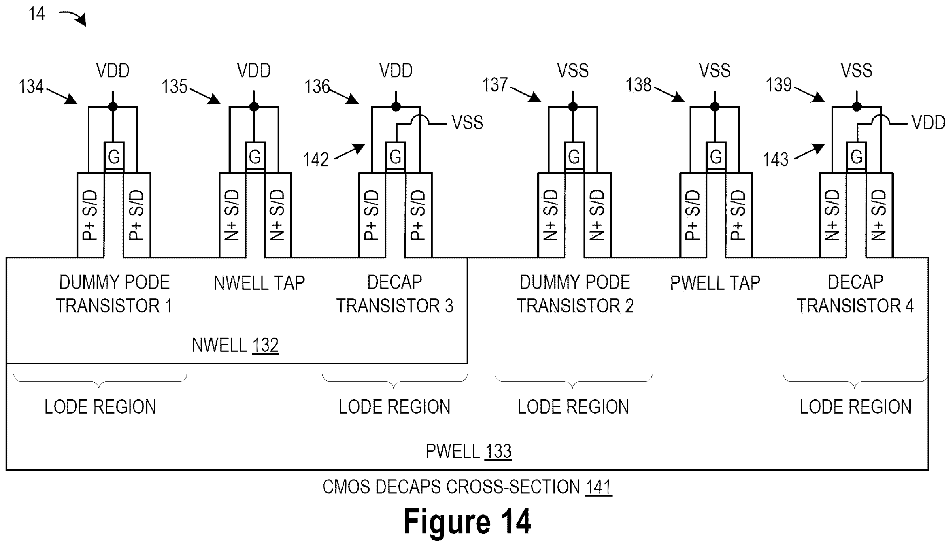

To illustrate the electrical connection of the LOD-protected well tap transistors 135, 138 in the sixth CMOS decap well tap cell design 131 shown in Figure 13, reference is now made to Figure 14 which depicts a simplified cross sectional view 14 of the sixth CMOS decap well tap cell design 141 taken along the cross-sectional path shown 130 shown in Figure 13. Except for the electrical connections to the supply and ground voltages, the FinFETs 136-139 may be structurally identical to the FinFETs 16-19 shown in Figures 1-2. As depicted, each of the dummy PODE transistors 134 and the n-well tap FinFET 135 formed in the n-well region 132 has a supply voltage VDD connected to the shorted gate, source and drain regions. Likewise, each of the dummy PODE transistors 137 and the p-well tap FinFET 138 formed in the p-well region 133 has a ground voltage VSS connected to the shorted gate, source and drain regions. However, with the formation of additional metal interconnect layers 142, the decap-coupled transistor 136 is connected in an open gated configuration where the P+ source/drain regions are shorted together and connected to the supply voltage VDD and where the gate electrode is connected to the ground voltage VSS. In addition, with the formation of additional metal interconnect layers 143, the decap-coupled transistor 139 is also connected in an open gated configuration where the N+ source/drain regions are shorted together and connected to the ground voltage VSS and where the gate electrode is connected to the supply voltage VDD.

As depicted in Figures 13-14, the P+ and N+ decap-coupled transistors 136, 139 of the sixth CMOS decap well tap cell design 131 are positioned in the right-most LODE protection regions of the n-well region 132 and p-well region 133. In the n-well region 132, the P+ decap-coupled transistor 136 and dummy PODE transistor 134 combine to protect the n-well tap FinFET 135. In addition, the N+ decap-coupled transistor 139 and dummy PODE transistor 137 formed in the p-well region 133 combine to protect the p-well tap FinFET 138. The performance and/or functional benefits of positioning the decap-coupled transistors 136, 139 in the right-most LODE protection regions along the cross-sectional path 130 through the n-well region 132 and p-well region 133 include, but are not limited to higher capacitance per area.

As disclosed herein, the specific placement and spacing of the decap-coupled transistors and well tap transistors in the n-well and p-well regions of the standard well tap cell will depend on the design layout restrictions required by the specific cell layout requirements, though generally speaking, any adjacent rows of N+ decap-coupled transistors (or alternatively, P+ decap-coupled transistors) should be aligned for connection to form a decoupling capacitor between the ground and supply voltages. In addition, the n-well and p-well tap transistors may be positioned in non-overlapping positions so that separate gate electrodes can provide the required reference/supply voltage to each n-well and p-well tap transistor.

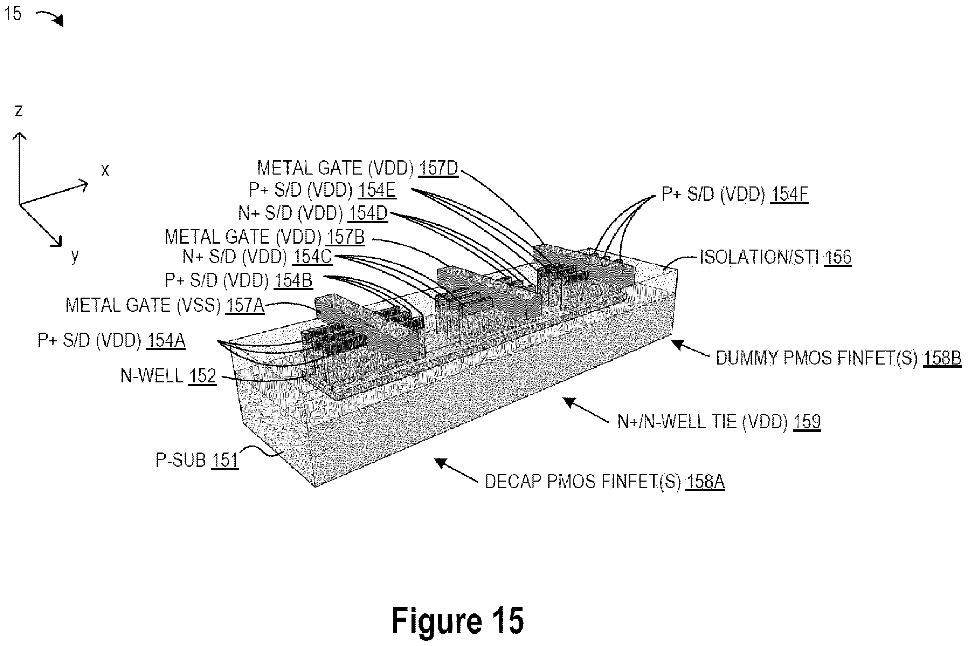

For an improved understanding of selected embodiments of the present disclosure, reference is now made to Figure 15 which depicts a perspective view of an n-well tap cell 15 which includes a plurality of N+/n-well tie FinFETs 159 with a plurality of decap-coupled PMOS FinFETs 158A and a plurality of dummy PMOS FinFETs 158B formed in a p-type substrate 151 which are connected in a configuration corresponding to the n-well tap in the first CMOS well tap cell design described hereinabove with reference to Figures 3-4. In particular, the plurality of decap-coupled PMOS FinFETs 158A and the plurality of dummy PMOS FinFETs 158B are located on opposite sides of a centrally positioned plurality of N+/n-well tie FinFETs 159.

The depicted plurality of decap-coupled PMOS FinFETs 158A includes a plurality of parallel P+ source/drain regions 154A, 154B formed on a plurality of parallel n-type fin structures which are aligned in the x-direction to extend up (in the z-direction) from the underlying n-well region 152 formed in the p-substrate 151. As formed, the plurality of parallel P+ source/drain regions 154A, 154B extend above the shallow trench isolation (STI) layer 156 so that they are separated in both the x-direction and y-direction by STI layers 156. The depicted plurality of decap-coupled PMOS FinFETs 158A also includes one or more metal gate electrode layers 157A extending perpendicularly in the y-direction to overlap with the plurality of parallel n-type fin structures, thereby forming P+ fin source/drain regions 154A, 154B. Completing the plurality of decap-coupled PMOS FinFETs 158A, one or more source/drain contact/metal/interconnect layers (not shown) may be formed to electrically connect the P+ source/drain regions 154A, 154B to the supply voltage VDD. In addition, one or more gate contact/metal/interconnect layers (not shown) may be formed to electrically connect the metal gate electrode layers 157A to the ground voltage VSS. With the P+ source/drain regions 154A, 154B connected together to form a first decoupling capacitor plate that is electrically connected to the supply voltage VDD, and with the gate electrode forming a second decoupling capacitor plate that is electrically connected to the ground voltage VSS, a decoupling capacitor is formed between the ground and supply voltages.

The depicted plurality of dummy PMOS FinFETs 158B may be formed on the opposite end of the n-well 152 with an identical structure, including a metal gate electrode 157D and a plurality of parallel P+ source/drain regions 154E, 154F. However, the metal gate electrode 157D and a plurality of parallel P+ source/drain regions 154E, 154F are all shorted together and connected to a shared supply voltage VDD to form a PFET dummy device. In particular, one or more source/drain/gate contact/metal/interconnect layers (not shown) may be formed to electrically connect the P+ source/drain regions 154E, 154F and the metal gate electrode layers 157D to the supply voltage VDD. As a result, a PFET dummy device is formed which has a first terminal (formed in the n-well region 152) and a second terminal (formed by the shorted gate 157D and plurality of parallel P+ source/drain regions 154E, 154F).

Between the plurality of decap-coupled PMOS FinFETs 158A and the plurality of dummy PMOS FinFETs 158B, the plurality of N+/n-well tie FinFETs 159 may be formed using the same basic structure, though connected differently through the metal interconnect layers. In particular, the depicted plurality of N+/n-well tie FinFETs 159 is formed with a plurality of parallel N+ source/drain regions 154C, 154D which are aligned in the x-direction to extend up from the underlying n-well region 152 and to protrude above the shallow trench isolation (STI) layer 156 so that they are separated in both the x-direction and y-direction by STI layers 156. The depicted plurality of N+/n-well tie FinFETs 159 may also include one or more metal gate electrode layers 157B extending perpendicularly in the y-direction to overlap with the plurality of parallel N+ source/drain regions 154C, 154D. Completing the plurality of N+/n-well tie FinFETs 159, one or more source/drain contact layers (not shown) may be formed to electrically connect the N+ source/drain regions 154C, 154D and the metal gate electrode layers 157B to the supply voltage VDD.

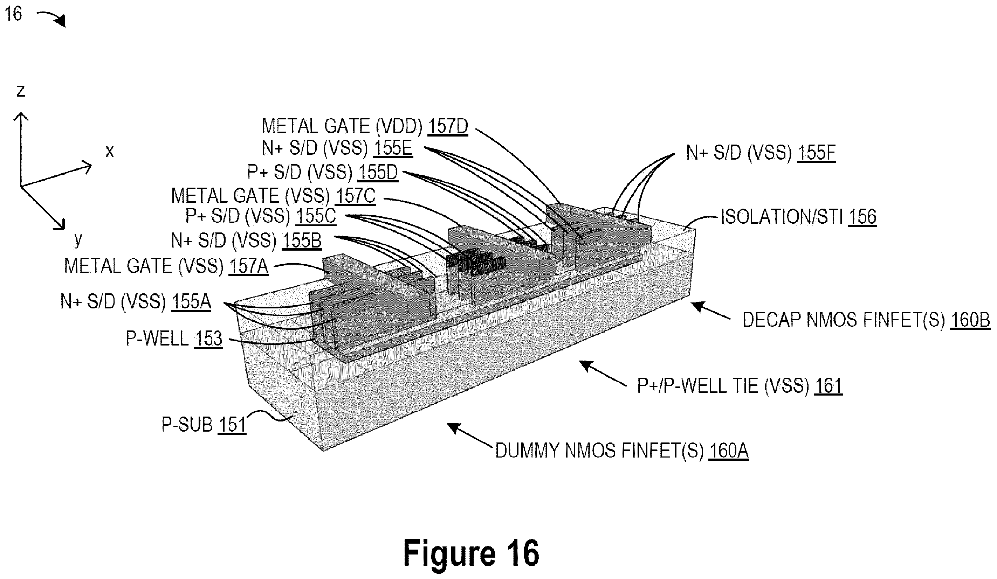

For an improved understanding of selected embodiments of the present disclosure, reference is now made to Figure 16 which depicts a perspective view of a p-well tap cell 16 which includes a plurality of P+/p-well tie FinFETs 161 with a plurality of dummy NMOS FinFETs 160A and a plurality of decap-coupled NMOS FinFETs 160B formed in a p-type substrate 151 which are connected in a configuration corresponding to the p-well tap in the first CMOS well tap cell design described hereinabove with reference to Figures 3-4. In particular, the plurality of dummy NMOS FinFETs 160A and the plurality of decap-coupled NMOS FinFETs 160B are located on opposite sides of a centrally positioned plurality of P+/p-well tie FinFETs 161.

As depicted, the plurality of dummy NMOS FinFETs 160A includes a plurality of parallel N+ source/drain regions 155A, 155B formed on a plurality of parallel p-type fin structures which are aligned in the x-direction to extend up (in the z-direction) from the underlying p-well region 153 formed in the p-substrate 151. As formed, the plurality of parallel N+ source/drain regions 155A, 155B extend above the STI layer 156 so that they are separated in both the x-direction and y-direction by STI layers 156. The depicted plurality of dummy NMOS FinFETs 160A also includes one or more metal gate electrode layers 157A extending perpendicularly in the y-direction to overlap with the plurality of parallel p-type fin structures, thereby forming N+ fin source/drain regions 155A, 155B. Completing the plurality of dummy NMOS FinFETs 160A, one or more source/drain/gate contact/metal/interconnect layers (not shown) may be formed to electrically connect the N+ source/drain regions 155A, 155B and the metal gate electrode layers 157A to the ground voltage VSS to form an NFET dummy device which has a first terminal (formed in the p-well region 153) and a second terminal (formed by the shorted gate 157A and plurality of parallel N+ source/drain regions 155A, 155B).

The depicted plurality of decap-coupled NMOS FinFETs 160B may be formed on the opposite end of the p-well 153 with an identical structure, including a metal gate electrode 157D and a plurality of parallel N+ source/drain regions 155E, 155F. However, the metal gate electrode 157D and the plurality of parallel N+ source/drain regions 155E, 155F are separately connected to different reference voltages to form the decoupling capacitor. In particular, one or more source/drain contact/metal/interconnect layers (not shown) may be formed to electrically connect the N+ source/drain regions 155E, 155F to the ground voltage VSS. In addition, one or more gate contact/metal/interconnect layers (not shown) may be formed to electrically connect the metal gate electrode layers 157D to the supply voltage VDD. With the N+ source/drain regions 155E, 155F connected together to form a first decoupling capacitor plate that is electrically connected to the ground voltage VSS, and with the gate electrode 157D forming a second decoupling capacitor plate that is electrically connected to the supply voltage VDD, a decoupling capacitor is formed between the ground and supply voltages.

And while the labeling of the metal gate electrode layers 157A, 157D in both Figures 15 and 16 indicates that these may be part of the same gate electrode layer extending over both the n-well tap cell 15 and the p-well tap cell 16, this is not required in every embodiment. For example, separate gate electrode layers could be used for the plurality of decap-coupled PMOS FinFETs 158A and the plurality of dummy NMOS FinFETs 160A. Similarly, separate gate electrode layers could be used for the plurality of dummy NMOS FinFETs 158B and the plurality of decap-coupled NMOS FinFETs 160B.

Between the plurality of dummy NMOS FinFETs 160A and the plurality of decap-coupled NMOS FinFETs 160B, the plurality of P+/p-well tie FinFETs 161 may be formed using the same basic structure, though connected differently through the metal interconnect layers. In particular, the depicted plurality of P+/p-well tie FinFETs 161 is formed with a plurality of parallel P+ source/drain regions 155C, 155D which are aligned in the x-direction to extend up from the underlying p-well region 153 and to protrude above the STI layer 156 so that they are separated in both the x-direction and y-direction by STI layers 156. The depicted plurality of P+/p-well tie FinFETs 161 may also include one or more metal gate electrode layers 157C extending perpendicularly in the y-direction to overlap with the plurality of parallel P+ source/drain regions 155C, 155D. Completing the plurality of P+/p-well tie FinFETs 161, one or more source/drain contact layers (not shown) may be formed to electrically connect the P+ source/drain regions 155C, 155D and the metal gate electrode layers 157C to the ground voltage VSS.

As will be appreciated, the embodiments disclosed herein are not limited to a particular material for the gate electrode, resistor or metal interconnect layers. For example, gate electrodes may be formed with one or more polysilicon or metal layers over a gate dielectric or insulating layer formed with a high-K dielectric material, such as hafnium based oxide, a hafnium based oxynitride, or a hafnium-silicon oxynitride, hafnium silicate, zirconium silicate, hafnium dioxide and zirconium dioxide.

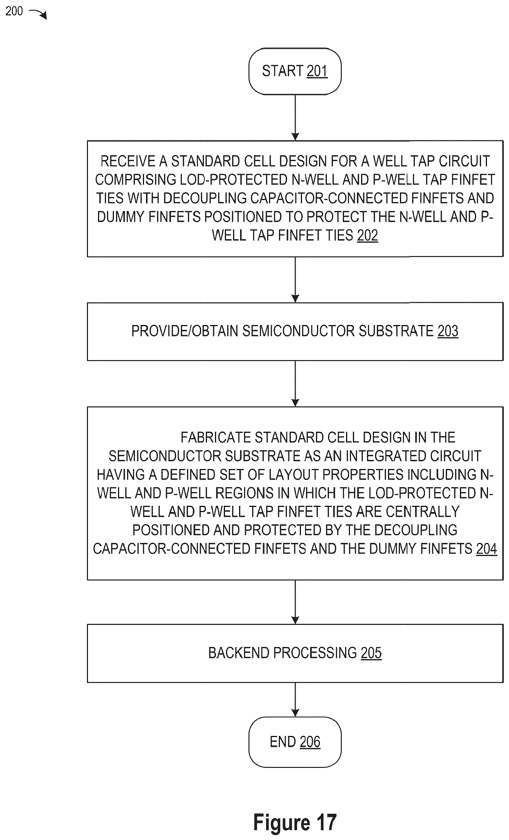

To further illustrated selected embodiments of the present disclosure, reference is now made to Figure 17 which is a simplified schematic flow chart 200 illustrating various methods for fabricating an integrated circuit with a standard well tap cell design. In describing the fabrication methodology 200, the description is intended merely to facilitate understanding of various exemplary embodiments and not by way of limitation. Unless otherwise indicated, the identified processing steps 201-206 may be implemented with one or more individual fabrications steps, including but not limited to depositing, growing, masking, developing, exposing, patterning, implanting, doping, etching, cleaning, stripping, annealing, and/or polishing that are performed in any desired order. Since the steps illustrated in Figure 17 and described below are provided by way of example only, it will be appreciated that alternative embodiments of fabrication method 200 may include additional steps, omit certain steps, substitute or alter certain steps, or perform certain steps in an order different than that illustrated in Figure 17.

Once the fabrication methodology starts (step 201), a standard cell design for a well tap circuit is received. In selected embodiments, the standard cell design includes an LOD-protected n-well tap FinFET tie and p-well tap FinFET tie along with a plurality of decoupling capacitor-connected FinFETs and a plurality of dummy FinFETs which are positioned to protect one or more of the n-well and p-well tap FinFET ties. In accordance with selected embodiments, the protective distribution of decoupling capacitor-connected FinFETs and dummy FinFETs can include one or more decoupling capacitor-connected FinFETs positioned next to a protected n-well tap FinFET tie or p-well tap FinFET tie.

At step 203, a semiconductor substrate is provided or obtained. For example, a semiconductor wafer structure may be provided which is formed with a semiconductor substrate structure having a predetermined crystallographic orientation and thickness (e.g., approximately 0.6 mm for FinFET technology node). Depending on the type of transistor device being fabricated, the semiconductor substrate structure may be implemented as a bulk silicon substrate, single crystalline silicon (doped or undoped), epitaxial semiconductor material, SOI substrate, or any semiconductor material including, for example, Si, Si C, SiGe, SiGeC, Ge, GaAs, InAs, InP as well as other Group III-V compound semiconductors or any combination thereof, and may optionally be formed as the bulk handling wafer. As will be appreciated, the semiconductor substrate structure may be appropriately doped to provide n-type (electron) or p-type (hole) carriers.

At step 204, a sequence of steps are used to fabricate the standard cell design in the semiconductor substrate as an integrated circuit having a defined set of layout properties which include an n-well region and a p-well region which may be adjacent to one another and which extend across the standard cell. The layout properties may also specify that the n-well and p-well regions include LOD-protected n-well and p-well tap FinFET ties that are centrally positioned and protected by the decoupling capacitor-connected FinFETs and the dummy FinFETs. In selected embodiments, the n-well tap FinFET tie is located in a central section of the n-well region for connecting the n-well to a first supply voltage (e.g., VDD), and the p-well tap FinFET tie is located in a central section of the p-well region for connecting the p-well to a second supply voltage (e.g., VSS). The layout properties also include a dummy FinFET layout area positioned on one or both sides of the LOD-protected n-well or p-well tap FinFET ties. As formed, the dummy FinFET layout area may include one or more p-FinFETs formed in the n-well region and connected as a first dummy device with the gate, source, and drain regions shorted to the first supply voltage. Alternatively, the dummy FinFET layout area may include one or more n-FinFETs formed in the p-well region and connected as a second dummy device with the gate, source, and drain regions shorted to the second supply voltage. In addition, the layout properties also include a decap FinFET layout area positioned on one or both sides of the LOD-protected n-well or p-well tap FinFET ties. As formed, the decap FinFET layout area may include one or more p-FinFETs formed in the n-well region with the gate connected to the second supply voltage and with the shorted source and drain regions connected to the first supply voltage. Alternatively, the decap FinFET layout area may include one or more n-FinFETs formed in the p-well region with the gate connected to the first supply voltage and with the shorted source and drain regions connected to the second supply voltage.

When fabricating the standard cell, the sequence of fabrication steps may include selectively implanting a single row standard cell area of the semiconductor substrate with the n-well and p-well regions. In addition, the fabrication steps may include selectively forming a plurality of semiconductor fins on the semiconductor substrate extending up from the n-well and p-well regions. In addition, the plurality of semiconductor fins may be selectively implanted to form P+ doped source/drain regions over the n-well region in one or more defined P+ active areas of the dummy FinFET layout area (and/or decap FinFET layout area), N+ doped source/drain regions formed over the n-well region in the tap area, N+ doped source/drain regions formed over the p-well region in one or more defined N+ active areas of the dummy FinFET layout area (and/or decap FinFET layout area), and P+ doped source/drain regions formed over the p-well region in the tap area. As will be appreciated, the fabrication steps may be formed with a combination of epitaxial semiconductor growth and/or selective etch processes. Non-limiting example of epitaxial growth include ultra-high vacuum chemical vapor deposition (UHV-CVD) at low temperature (e.g., around 550 °C.), and/or low pressure chemical vapor deposition (LP-CVD) at higher temperature (e.g., around 900 °C) and by other means known in the art. In addition, the fabrication steps may include selectively forming one or more FinFET gate electrodes aligned perpendicularly to the plurality of semiconductor fins to define the desired p-FinFET and n-FinFET devices in the dummy FinFET layout area and/or decap FinFET layout area. Finally, the fabrication steps may include selectively forming one or more metal interconnect layers over the substrate to connect the p-FinFET and n-FinFET devices in the dummy FinFET layout area connect the p-FinFET and n-FinFET devices in the decap FinFET layout area as decoupling capacitors, to tie the semiconductor fins formed over the n-well region to the first supply voltage, and to tie the semiconductor fins formed over the p-well region to the second supply voltage.

At step 205, implanting and backend processing are performed before the fabrication methodology ends at step 206. Such backend processing may include thermal treatments for the implanted regions are applied at some point in the fabrication sequence to activate the implanted regions and otherwise repair implantation damage. In addition, other circuit features may be formed on the wafer structure, such as transistor devices, using one or more of sacrificial oxide formation, stripping, isolation region formation, well region formation, gate dielectric and electrode formation, extension implant, halo implant, spacer formation, source/drain implant, heat drive or anneal steps, and polishing steps, along with conventional backend processing (not depicted), typically including formation of multiple levels of interconnect that are used to connect the transistors in a desired manner to achieve the desired functionality. Thus, the specific sequence of steps used to complete the fabrication of the semiconductor structures may vary, depending on the process and/or design requirements.

Accordingly, the fabrication method 200 provides the overall process flow sequence for making a standard cell design for a well tap circuit. It should be understood that certain steps in the process flow sequence 200 may be performed in parallel with each other or with performing other processes. In addition, the particular ordering of the process flow sequence 200 may be modified, while achieving substantially the same result. Accordingly, such modifications are intended to be included within the scope of the inventive subject matter.

By now it should be appreciated that there has been provided an integrated circuit device having a compact standard well tap cell and associated methods of operation and fabrication. As disclosed, the integrated circuit device includes a semiconductor substrate having a first region doped with a first-type dopant and a second region doped with a second-type dopant different from the first-type dopant. In selected embodiments, the first-type dopant is n-type and the second-type dopant is p-type. In the disclosed standard well tap cell, a first tie transistor is disposed between a first plurality of Length of Diffusion (LOD) protection transistors in the first region of the semiconductor substrate. In addition, a second tie transistor is disposed between a second plurality of LOD protection transistors in the second region of the semiconductor substrate. The disclosed first and second plurality of LOD protection transistors include a first transistor connected as a first decoupling capacitor between a first voltage supply and a second voltage supply. In addition, the disclosed first and second plurality of LOD protection transistors include a second transistor connected as a second decoupling capacitor between the first voltage supply and the second voltage supply. The disclosed first and second plurality of LOD protection transistors also include a plurality of additional dummy transistors, each having gate, source, and drain terminal connected in common to either the first voltage supply and the second voltage supply. In selected embodiments, the first and second tie transistors, the first plurality of LOD protection transistors, and the second plurality of LOD protection transistors are each formed with a Fin Field Effect Transistor (FinFET) device. In such embodiments, the first tie transistor may be embodied as a first FinFET device which includes (1) a body well region formed in the first region of the semiconductor substrate, and (2) shorted gate, source, and drain regions connected to the first supply voltage. In addition, the second tie transistor may be embodied as a second FinFET device which includes (1) a body well region formed in the second region of the semiconductor substrate, and (2) shorted gate, source, and drain regions connected to the second supply voltage. In addition, the first transistor may be embodied with a first decap FinFET device which includes (1) a gate connected to one of the first or second supply voltages, and (2) shorted source and drain regions connected to the other of the first or second supply voltages. In addition, the plurality of additional dummy transistors may include a first dummy FinFET device which has shorted gate, source, and drain regions connected to either the first supply voltage or the second supply voltage. In selected embodiments, the first tie transistor may be embodied as an n-FinFET formed in the first region of the semiconductor substrate, the second tie transistor may be embodied as a p-FinFET formed in the second region of the semiconductor substrate, the first transistor connected as a first decoupling capacitor may be embodied as a p-FinFET formed in the first region of the semiconductor substrate, and the second transistor connected as a second decoupling capacitor may be embodied an n-FinFET formed in the second region of the semiconductor substrate. In addition, each of the plurality of additional dummy transistors may be embodied as a p-FinFET formed in the first region of the semiconductor substrate or an n-FinFET formed in the second region of the semiconductor substrate.

In another form, there has been provided an integrated circuit device and method of manufacture and operation wherein a plurality of standard well tap cells are connected to a first supply voltage and a second supply voltage. As disclosed, each standard well tap cell has set of layout properties which include first and second semiconductor substrate regions extending across the standard well tap cell, wherein the first semiconductor substrate region is doped with a first-type dopant, wherein the second semiconductor substrate region is doped with a second-type dopant different from the first-type dopant, and wherein the first and second semiconductor substrate regions are formed adjacent to one another in a semiconductor substrate. The layout properties also include a first tie transistor disposed between a first plurality of Length of Diffusion (LOD) protection transistors in the first semiconductor substrate region, wherein the first tie transistor has a gate, source, and drain terminal connected in common to the first supply voltage. In selected embodiments, the first tie transistor is a FinFET device which includes (1) an n-type body well region formed in the first semiconductor substrate region of the semiconductor substrate, and (2) shorted gate, source, and drain regions connected to the first supply voltage. In addition, the layout properties include a second tie transistor disposed between a second plurality of LOD protection transistors in the second semiconductor substrate region, wherein the second tie transistor has a gate, source, and drain terminal connected in common to the second supply voltage. In selected embodiments, the second tie transistor is a FinFET device which includes (1) a p-type body well region formed in the second semiconductor region of the semiconductor substrate, and (2) shorted gate, source, and drain regions connected to the second supply voltage. In selected embodiments, the first tie transistor is an n-well tie transistor located in a central section of the first semiconductor substrate region which is an n-well region which is connected over the n-well tie transistor to the first supply voltage, and the second tie transistor is an p-well tie transistor located in a central section of the second semiconductor substrate region which is a p-well region which is connected over the p-well tie transistor to the second supply voltage. In the disclosed layout properties, the first plurality of LOD protection transistors and the second plurality of LOD protection transistors collectively include at least one decap transistor connected as a decoupling capacitor between the first supply voltage and the second supply voltage, and also include a plurality of additional dummy transistors, wherein each additional dummy transistor has a gate, source, and drain terminal connected in common to either the first supply voltage or the second supply voltage. In selected embodiments, the at least one decap transistor is a FinFET device which includes (1) an body well region formed in the first or second semiconductor substrate regions of the semiconductor substrate, (2) shorted source and drain regions connected to one of the first or second supply voltage, and (3) a gate connected to the other of the first or second supply voltage. In selected embodiments, each of the first tie transistor, second tie transistor, first plurality of LOD protection transistors, and the second plurality of LOD protection transistors may be a Fin Field Effect Transistor (FinFET) device formed in the first semiconductor substrate region or the second semiconductor substrate region of the semiconductor substrate. In selected embodiments, the first plurality of LOD protection transistors and the second plurality of LOD protection transistors collectively include at least a two decap transistors connected as decoupling capacitors between the first supply voltage and the second supply voltage. In selected embodiments, the first tie transistor is an n-FinFET formed in the first semiconductor substrate region of the semiconductor substrate, the second tie transistor is a p-FinFET formed in the second semiconductor substrate region of the semiconductor substrate, and the at least one decap transistor connected as a decoupling capacitor is a p-FinFET formed in the first semiconductor substrate region of the semiconductor substrate and/or an n-FinFET formed in the second semiconductor substrate region of the semiconductor substrate. In addition, each of the plurality of additional dummy transistors may be a p-FinFET formed in the first semiconductor substrate region of the semiconductor substrate or an n-FinFET formed in the second semiconductor substrate region of the semiconductor substrate.

In yet another form, there has been provided an integrated circuit device and method of manufacture and operation same. As disclosed, the fabrication method includes receiving a standard well tap cell design for a well tap circuit for connecting a first supply voltage and a second supply voltage to, respectively, an n-type semiconductor substrate region and a p-type semiconductor substrate region. In addition, the fabrication method includes using a sequence of fabrication processing steps to form the standard well tap cell design as an integrated circuit having set of layout properties. As formed, the layout properties include an n-well tie located in the n-type semiconductor substrate region for connecting the n-type semiconductor substrate region to the first supply voltage. The layout properties also include a first plurality of Length of Diffusion (LOD) protection transistors located in the n-type semiconductor substrate region to protect the n-well tie. In addition, the layout properties include a p-well tie located in the p-type semiconductor substrate region for connecting the p- type semiconductor substrate region to the second supply voltage. The layout properties also include a second plurality of LOD protection transistors located in the p-type semiconductor substrate region to protect the p-well tie. As formed, the first plurality of LOD protection transistors and the second plurality of LOD protection transistors collectively include (1) at least one decap transistor connected as a decoupling capacitor between the first supply voltage and the second supply voltage, and (2) a plurality of additional dummy transistors, wherein each additional dummy transistor has a gate, source, and drain terminal connected in common to either the first supply voltage or the second supply voltage. In one embodiment, three decap transistors and one dummy transistor may be included. And in another embodiments, one decap transistor and three dummy transistors may be included. In selected embodiments, the sequence of fabrication processing steps for forming the standard well tap cell design includes obtaining a semiconductor substrate and selectively implanting the semiconductor substrate to form the n-type semiconductor substrate region and the p-type semiconductor substrate region to be adjacent to one another. The sequence of fabrication processing steps also includes selectively forming a plurality of semiconductor fins on the semiconductor substrate extending up from the n-type semiconductor substrate region and the p-type semiconductor substrate region. As formed, the plurality of semiconductor fins includes P+ doped semiconductor fins formed over the n-type semiconductor substrate region in one or more defined Length of Diffusion (LOD) protection areas; N+ doped semiconductor fins formed over the n-type semiconductor substrate region in one or more defined n-tap areas; N+ doped semiconductor fins formed over the p-type semiconductor substrate region in one or more defined LOD protection areas; and P+ doped semiconductor fins formed over the p-type semiconductor substrate region in one or more defined p- tap areas. In addition, the sequence of fabrication processing steps includes selectively forming one or more gate electrodes aligned perpendicularly to the plurality of semiconductor fins to define a first plurality of LOD protection transistors in the n-type semiconductor substrate region and a second plurality of LOD protection transistors in the p-type semiconductor substrate region. Finally, the sequence of fabrication processing steps includes selectively forming one or more metal interconnect layers over the semiconductor substrate to connect the first plurality of LOD protection transistors and the second plurality of LOD protection transistors to form (1) at least one decap FinFET device connected as a first decoupling capacitor between the first voltage supply and the second voltage supply, and (2) a plurality of additional dummy FinFET devices, wherein each additional dummy FinFET device has a gate, source, and drain terminal connected in common to either the first voltage supply or the second voltage supply.

Although the described exemplary embodiments disclosed herein are directed to a well tap cell design and methodology which uses "dummy" FinFETs connected in combination with decap FinFETS connected between the supply and ground voltages, the present invention is not necessarily limited to the example embodiments which illustrate inventive aspects of the present invention that are applicable to a wide variety of circuit designs and operations. For example, the present disclosure depicts various well tap cell configurations having a pair of decap-coupled dummy transistors in different locations of each well tap cell, but there may be additional or fewer decap-coupled dummy transistors included in each well tap cell, provided that at least one decap-coupled dummy transistor is included in each well tap cell. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the identification of the circuit design and layout configurations provided herein is merely by way of illustration and not limitation and other circuit arrangements may be used in order to provide well tap cell functionality with an area-efficient standard cell design. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

The preceding merely illustrates the principles of certain examples. It will thus be appreciated that those skilled in the art will be able to devise various arrangements which, although not explicitly described or shown herein, embody the principles and are included within their scope. Furthermore, all examples and conditional language recited herein are principally intended expressly to be only for pedagogical purposes and to aid the reader in understanding the principles and the concepts contributed by the inventors to furthering the art, and are to be construed as being without limitation to such specifically recited examples and conditions. Moreover, all statements herein reciting principles, aspects, and embodiments, as well as specific examples thereof, are intended to encompass both structural and functional equivalents thereof. Additionally, it is intended that such equivalents include both currently known equivalents and equivalents developed in the future, i.e., any elements developed that perform the same function, regardless of structure.

This description of the exemplary embodiments is intended to be read in connection with the figures of the accompanying drawing, which are to be considered part of the entire written description. In the description, relative terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An integrated circuit device comprising a standard well tap cell disposed over a semiconductor substrate comprising a first region doped with a first-type dopant and a second region doped with a second-type dopant different from the first-type dopant, the standard well tap cell comprising:
a first tie transistor disposed between a first plurality of Length of Diffusion (LOD) protection transistors in the first region of the semiconductor substrate; and
a second tie transistor disposed between a second plurality of LOD protection transistors in the second region of the semiconductor substrate;
where the first plurality of LOD protection transistors and the second plurality of LOD protection transistors collectively comprise:
a first transistor connected as a first decoupling capacitor between a first voltage supply and a second voltage supply,
a second transistor connected as a second decoupling capacitor between the first voltage supply and the second voltage supply, and
a plurality of additional dummy transistors, each having a gate, source, and drain terminal connected to either the first supply voltage or the second supply voltage.

2. The integrated circuit device of claim 1, where the first-type dopant is n-type and the second-type dopant is p-type.

3. The integrated circuit device of claim 1 or claim 2, where the first and second tie transistors, the first plurality of LOD protection transistors, and the second plurality of LOD protection transistors are each formed with a Fin Field Effect Transistor (FinFET) device.

4. The integrated circuit device of claim 3, where the first tie transistor comprises a first FinFET device comprising (1) a body well region formed in the first region of the semiconductor substrate, and (2) shorted gate, source, and drain regions connected to the first supply voltage.

5. The integrated circuit device according to any preceding claims, where the second tie transistor comprises a second FinFET device comprising (1) a body well region formed in the second region of the semiconductor substrate, and (2) shorted gate, source, and drain regions connected to the second supply voltage.

6. The integrated circuit device of claim 3, where the first transistor comprises a first decap FinFET device comprising (1) a gate connected to one of the first or second supply voltages, and (2) shorted source and drain regions connected to the other of the first or second supply voltages.

7. The integrated circuit device of claim 3, where the plurality of additional dummy transistors comprises a first dummy FinFET device comprising shorted gate, source, and drain regions connected to either the first supply voltage or the second supply voltage.

8. The integrated circuit according to any preceding claim,
where the first tie transistor comprises an n-FinFET formed in the first region of the semiconductor substrate,
where the second tie transistor comprises a p-FinFET formed in the second region of the semiconductor substrate,
where the first transistor connected as a first decoupling capacitor comprises a p-FinFET formed in the first region of the semiconductor substrate, and
where the second transistor connected as a second decoupling capacitor comprises an n-FinFET formed in the second region of the semiconductor substrate.

9. The integrated circuit device of claim 1, where each of the plurality of additional dummy transistors comprises a p-FinFET formed in the first region of the semiconductor substrate or an n-FinFET formed in the second region of the semiconductor substrate.

10. An integrated circuit device comprising a plurality of standard well tap cells connected to a first supply voltage and a second supply voltage, each standard well tap cell having a set of layout properties comprising:
first and second semiconductor substrate regions extending across the standard well tap cell, wherein the first semiconductor substrate region is doped with a first-type dopant, wherein the second semiconductor substrate region is doped with a second-type dopant different from the first-type dopant, and wherein the first and second semiconductor substrate regions are formed adjacent to one another in a semiconductor substrate;
a first tie transistor disposed between a first plurality of Length of Diffusion (LOD) protection transistors in the first semiconductor substrate region, wherein the first tie transistor has a gate, source, and drain terminal connected in common to the first supply voltage; and
a second tie transistor disposed between a second plurality of LOD protection transistors in the second semiconductor substrate region, wherein the second tie transistor has a gate, source, and drain terminal connected in common to the second supply voltage;
where the first plurality of LOD protection transistors and the second plurality of LOD protection transistors collectively comprise:
at least one decap transistor connected as a decoupling capacitor between the first supply voltage and the second supply voltage, and
a plurality of additional dummy transistors, wherein each additional dummy transistor has a gate, source, and drain terminal connected in common to either the first supply voltage or the second supply voltage.

11. The integrated circuit device of claim 10, wherein the first tie transistor is an n-well tie transistor located in a central section of the first semiconductor substrate region which is an n-well region which is connected over the n-well tie transistor to the first supply voltage, and wherein the second tie transistor is an p-well tie transistor located in a central section of the second semiconductor substrate region which is a p-well region which is connected over the p-well tie transistor to the second supply voltage.

12. The integrated circuit device of claim 10, wherein each of the first tie transistor, second tie transistor, first plurality of LOD protection transistors, and the second plurality of LOD protection transistors comprises a Fin Field Effect Transistor (FinFET) device formed in the first semiconductor substrate region or the second semiconductor substrate region of the semiconductor substrate.

13. The integrated circuit device of claim 10, where the first tie transistor comprises a FinFET device comprising (1) an n-type body well region formed in the first semiconductor substrate region of the semiconductor substrate, and (2) shorted gate, source, and drain regions connected to the first supply voltage.
substrate.

14. A method of fabricating an integrated circuit comprising:
receiving a standard well tap cell design for a well tap circuit for connecting a first supply voltage and a second supply voltage to, respectively, an n-type semiconductor substrate region and a p-type semiconductor substrate region; and
forming, with a sequence of fabrication processing steps, the standard well tap cell design in an integrated circuit to have a set of layout properties comprising:
an n-well tie located in the n-type semiconductor substrate region for connecting the n-type semiconductor substrate region to the first supply voltage;
a first plurality of Length of Diffusion (LOD) protection transistors located in the n-type semiconductor substrate region to protect the n-well tie,
a p-well tie located in the p-type semiconductor substrate region for connecting the p-type semiconductor substrate region to the second supply voltage; and
a second plurality of LOD protection transistors located in the p-type semiconductor substrate region to protect the p-well tie,
where the first plurality of LOD protection transistors and the second plurality of LOD protection transistors collectively comprise:
at least one decap transistor connected as a decoupling capacitor between the first supply voltage and the second supply voltage, and
a plurality of additional dummy transistors, wherein each additional dummy transistor has a gate, source, and drain terminal connected in common to either the first supply voltage or the second supply voltage.

15. The method of claim 14, where forming the standard well tap cell design comprises:
obtaining a semiconductor substrate;
selectively implanting the semiconductor substrate to form the n-type semiconductor substrate region and the p-type semiconductor substrate region to be adjacent to one another;
selectively forming a plurality of semiconductor fins on the semiconductor substrate extending up from the n-type semiconductor substrate region and the p-type semiconductor substrate region, where the plurality of semiconductor fins comprises:
P+ doped semiconductor fins formed over the n-type semiconductor substrate region in one or more defined Length of Diffusion (LOD) protection areas,
N+ doped semiconductor fins formed over the n-type semiconductor substrate region in one or more defined n-tap areas,
N+ doped semiconductor fins formed over the p-type semiconductor substrate region in one or more defined LOD protection areas, and
P+ doped semiconductor fins formed over the p-type semiconductor substrate region in one or more defined p- tap areas;
selectively forming one or more gate electrodes aligned perpendicularly to the plurality of semiconductor fins to define a first plurality of LOD protection transistors in the n-type semiconductor substrate region and a second plurality of LOD protection transistors in the p-type semiconductor substrate region; and
selectively forming one or more metal interconnect layers over the semiconductor substrate to connect the first plurality of LOD protection transistors and the second plurality of LOD protection transistors to comprise:
at least one decap FinFET device connected as a first decoupling capacitor between the first voltage supply and the second voltage supply, and
a plurality of additional dummy FinFET devices, wherein each additional dummy FinFET device has a gate, source, and drain terminal connected in common to either the first voltage supply or the second voltage supply.
